Europäisches Patentamt

European Patent Office

Office européen des brevets

(19)

(11) EP 0 627 611 B1

(12) FASCICULE DE BREVET EUROPEEN

(45) Date de publication et mention
de la délivrance du brevet:
01.10.1997 Bulletin 1997/40

(51) Int Cl.⁶: $G01B\ 11/14$, $H01L\ 21/66$

(21) Numéro de dépôt: 94401186.5

(22) Date de dépôt: 30.05.1994

(54) **Procédé et dispositif de contrôle de la conformité de billes d'hybridation**

Verfahren und Gerät zum Prüfen der Gleichförmigkeit von Hybridisierungskugeln

Method and device for conformity testing of hybridization balls

(84) Etats contractants désignés:
BE CH DE GB IT LI

(30) Priorité: 01.06.1993 FR 9306515

(43) Date de publication de la demande:
07.12.1994 Bulletin 1994/49

(73) Titulaire: COMMISSARIAT A L'ENERGIE
ATOMIQUE
75015 Paris (FR)

(72) Inventeurs:
• Caillat, Patrice
F-38130 Echirolles (FR)
• Parat, Guy
F-38130 Echirolles (FR)
• Nicolas, Gérard
F-38340 Voreppe (FR)

(74) Mandataire: Signore, Robert et al
c/o BREVATOME
25, rue de Ponthieu
75008 Paris (FR)

(56) Documents cités:
EP-A- 0 066 694    DE-A- 3 824 097

• NTIS TECH NOTES, Juin 1990, SPRINGFIELD,
VA US page 500 S.E. JOHNSON 'MEASURING
GAPS IN O-RING SEALS'
• IBM TECHNICAL DISCLOSURE BULLETIN,
vol.29, no.2, Juillet 1986, NEW YORK US pages
781 - 782 ANONYMOUS 'SURFACE-MOUNTED
COMPONENT LEAD CO-PLARARITY
MEASUREMENT TOOL'
• RESEARCH DISCLOSURE, no.333, Janvier 1992,
EMSWORTH GB page 13 ANONYMOUS
'SOLDER BALL CONNECTION CO-PLANARITY
WITH X-RAY TECHNOLOGY'

**Description**

Domaine technique

La présente invention a pour objet un procédé permettant de contrôler la conformité des billes d'hybridation, notamment d'une puce, d'un boîtier de puces, ou d'un susbtrat. On entend par conformité des billes, toutes les billes ayant une hauteur comprise entre une hauteur minimum hmin et une hauteur maximum hmax. Elle a en outre pour objet un dispositif assurant la mise en oeuvre de ce procédé. Elle trouve ses applications dans les domaines de la micro-électronique, de l'informatique et de l'électronique embarquée.

Etat de la technique

Une technique de report de composants électroniques sur un substrat d'interconnexion faisant appel à des micro-bossages (appelés également "billes") est aujourd'hui connue de l'homme de l'art. Cette technique de report est appelée "Flip-Chip". Selon cette technique Flip-Chip, les micro-bossages sont réalisés en un matériau fusible déposé par électrolyse ou évaporation, par exemple sur les plots de connexion des entrées/sorties du composant électronique. Ce matériau fusible peut être, par exemple, de l'Indium ou bien un alliage Etain-Plomb. L'opération de report du composant électronique sur le substrat se fait à une température de chauffe qui correspond au moins à la température de fusion du matériau fusible choisi cette opération de report s'apparente à un brasage.

Un tel procédé de report est nommé "C4" (ce qui signifie, en termes anglo-saxons, Control Collapse Chip Connection). Ce procédé fait l'objet de nombreuses publications ; il est décrit notamment dans l'ouvrage "Micropackaging handbook" de TUMMALA.

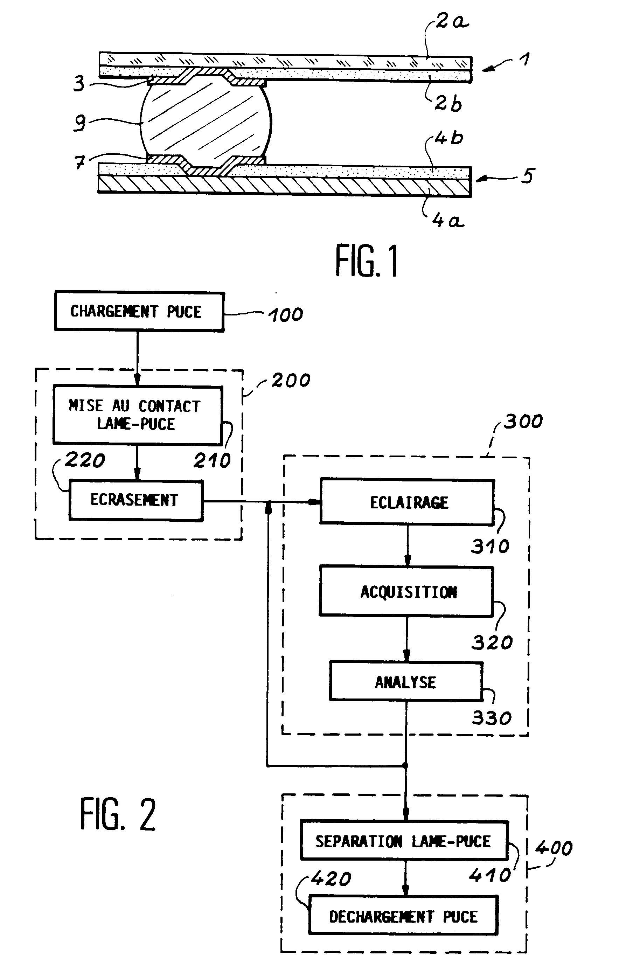

On a représenté, sur la figure 1, selon une vue de face, une bille d'hybridation assurant la connexion entre une puce 1 et un substrat 5. De façon plus précise, la puce 1 comporte une couche 2a de matériau électriquement conducteur en contact avec le plot de connexion 3. Une couche 2b électriquement isolante recouvre la face inférieure de la couche 2a autour du plot de sortie 3. Cette figure 1 montre également le substrat 5 qui comporte une couche 4a de matériau électriquement conducteur en contact avec le plot de connexion 7. Une couche 4b électriquement isolante recouvre la couche 4a autour du plot de connexion 7. La bille 9 d'hybridation assure la liaison électrique entre le plot de connexion 3 de la puce 1 et le plot de connexion 7 du substrat 5.

L'utilisation de plus en plus fréquente de modules multi-puces (multi-chips en terminologie anglosaxonne) implique une optimisation de la surface de substrat utile. C'est pourquoi, la technique du Flip-Chip est la technique la plus généralement utilisée dans le cas de multi-chips modules. Elle est, notamment, utilisée dans des secteurs à grande diffusion dans lesquels les impératifs de coûts sont importants. Ces dernières contraintes ont conduit à développer des procédés de réalisation de billes à base d'électrolyse plus économique que les procédés habituels faisant appel à l'évaporation.

De tels procédés de microbillage par électrolyse ont un inconvénient majeur qui réside dans la difficulté d'obtenir une homogénéité parfaite des dimensions des billes et, plus particulièrement, de leur hauteur.

Les puces munies de leurs billes sont ensuite assemblées avec un substrat par dépôt sur celui-ci. L'étape suivante consiste en une thermocompression (chauffage + pression) ou en un "solder reflow", c'est-à-dire un chauffage seul de l'ensemble puce-microbilles-substrat.

L'opération de thermocompression des puces peut permettre, par la pression exercée, de tolérer une certaine inhomogénéité de la hauteur des billes avant assemblage. Cependant, ce procédé est individuel ; cela signifie qu'il s'applique successivement à chacune des puces déposées sur le substrat : chaque puce est, en effet, pressée et chauffée l'une après l'autre ce qui nécessite, pour la réalisation d'un module multi-puces (pouvant comporter quelques 120 puces), un temps d'assemblage très long. En outre, il est difficile d'assurer une répartition de pression par bille conséquente sur des puces à très grand nombre d'entrées/sorties sans altérer le positionnement précis requis.

Aussi, le procédé "solder reflow" semble plus rapide à mettre en oeuvre et donc, moins onéreux. Cependant, ce procédé est moins tolérant à l'égard des inhomogénéités de hauteur des billes. Il convient donc de vérifier la hauteur des billes. Différentes méthodes ont été mises en oeuvre dans l'industrie pour vérifier la présence et la taille des billes d'hybridation des puces avant assemblage sur un substrat.

Dans la plupart des applications industrielles, les billes à vérifier ont une taille variant de 20 $\mu$ à 150 $\mu$ ; et cette vérification doit être faite avec une résolution de l'ordre de 5 %. De plus, pour des raisons de productivité, une telle vérification de la taille des billes doit être faite à une vitesse voisine de 150 ms/bille.

Une première méthode de mise en oeuvre consiste en l'analyse d'images à haute résolution. Cette méthode est mise en oeuvre au moyen d'un système dédié au contrôle des masques utilisés dans les ateliers de fabrication de circuits intégrés Silicium qui travaille en plan. La résolution obtenue par la mise en oeuvre de cette première méthode est inférieure au micron. Cependant, les essais effectués sur des structures non planes (dont font partie les billes) démontrent une vitesse incompatible avec les cadences du contrôle des billes d'hybridation de l'industrie.

Une seconde méthode met en oeuvre un système à autofocus qui est apte à faire la mise au point, d'une part, sur le sommet de la bille et, d'autre part, sur le substrat. Cette méthode permet d'obtenir le profil des billes selon une vitesse d'environ une seconde/bille. Cependant, l'obtention d'un profil complet des billes n'est pas nécessaire pour contrôler la taille des billes. En outre, la cadence permise par cette méthode est loin d'atteindre la vitesse de 150 ms/bille souhaitée.

Une troisième méthode met en oeuvre des micro-profilomètres, tels que ceux utilisés dans l'industrie du semi-conducteur pour vérifier des épaisseurs de dépôts. Ces appareils font appel au déplacement d'un stylet sur les structures à mesurer. Une adaptation de ces micro-profilomètres au contrôle de taille des billes a été envisagée. Cependant, pour des matériaux très mous tels que l'Indium, le marquage de la bille et l'encrassement du stylet sont loin d'être négligeables. De plus, le positionnement du stylet doit être très précis et la vitesse de contrôle réalisable n'est pas compatible avec celle requise.

Une quatrième méthode consiste en une triangulation laser. Cette méthode qui a l'avantage d'être très précise, est complexe à mettre en oeuvre et trop lente pour être compatible avec la cadence de 150 ms/bille souhaitée.

Une cinquième méthode consiste en l'analyse d'une ombre projetée. Selon cette méthode, l'image analysée est l'ombre de la bille obtenue par un éclairage incident à 45°. L'intérêt de la méthode réside dans "l'agrandissement" du sujet observé. Par contre, la définition obtenue étant liée à la topologie et à la propreté de la surface de la puce, cette méthode demande un réajustement du contraste pour chaque contrôle. Elle ne peut donc être intéressante que pour un seul état de surface. Lorsqu'il existe plusieurs états de surface, elle devient très complexe.

Enfin, une sixième méthode décrite dans Research Disclosure, no 33, Janvier 1992, Emsworth page 13, "Solder ball connection co-planarity with X-ray technology", consiste en une laminographie par rayons X.

## Exposé de l'invention

La présente invention a justement pour but de remédier à ces inconvénients. Pour cela, elle propose un procédé permettant de contrôler rapidement la présence et/ou la taille des billes montées, notamment selon la technique "solder reflow" sur une puce ou un substrat. Ce procédé consiste à utiliser les forts constrastes, créés en éclairant chacune des billes à contrôler, entre un méplat clair créé sur la bille à contrôler et le reste du champ optique contrôlé. Il consiste ensuite à analyser ces différences de contraste par comparaison.

De façon plus précise, l'invention concerne un procédé de contrôle de la conformité des billes d'hybridation présentes sur une face d'un composant électronique ou d'un substrat. Il se caractérise par le fait qu'il consiste en les étapes suivantes :

a) Positionnement des billes d'hybridation du composant électronique ou du substrat contre une lame transparente à une longueur d'onde λ ;
b) Ecrasement partiel desdites billes d'hybridation sur la lame transparente, cet écrasement créant des méplats de billes sur la lame ;
c) Eclairage des billes par un faisceau lumineux de longueur d'onde λ à travers la lame transparente ;
d) Acquisition du signal réfléchi par les billes d'hybridation à contrôler ;
e) Détermination de la conformité ou de la non-conformité respective des billes d'hybridation à contrôler en fonction du signal réfléchi par chacune d'elles.

Selon un premier mode de réalisation de l'invention, l'étape c) consiste à éclairer l'ensemble du composant électronique ou du substrat par le faisceau lumineux et l'étape d) consiste à acquérir le signal réfléchi par cet ensemble.

Selon un deuxième mode de réalisation de l'invention, l'étape c) consiste à éclairer une partie du composant électronique ou du substrat par le faisceau lumineux, ladite partie étant susceptible de comporter au moins une bille et l'étape d) consiste à acquérir le signal réfléchi correspondant, ces étapes c) et d) étant répétées de façon à contrôler l'ensemble du composant électronique ou du substrat.

Selon un mode de réalisation de l'invention, l'étape e) de détermination de la conformité des billes consiste à détecter, à partir du signal réfléchi acquis, la présence ou non d'un méplat lié à une bille, respectivement aux différents emplacements susceptibles d'être occupés par les billes.

Avantageusement, ces emplacements sont prédéfinis dans une base de données et mémorisés dans les moyens de traitement du dispositif de mise en oeuvre.

Selon un autre mode de réalisation de l'invention, l'étape e) de détermination de la conformité des billes consiste à détecter, à partir du signal réfléchi acquis, aux différents emplacements susceptibles d'être occupés par les billes, la présence ou non d'un méplat et à mesurer, dans le cas de la détection d'un méplat, la taille de ce dernier.

Selon un mode de réalisation de l'invention, l'étape b) d'écrasement des billes d'hybridation contre la lame transparente consiste à positionner le composant électronique ou le substrat à une distance prédéfinie de la lame transparente, cette distance correspondant à une hauteur théorique de bille de référence moins l'écart acceptable entre cette hauteur théorique de bille et la hauteur minimale des billes d'hybridation à contrôler pour que lesdites billes d'hybridation à contrôler soient conformes.

La présente invention propose en outre un dispositif pour mettre en oeuvre ce procédé.

Ce dispositif comporte :

. une lame transparente à la longueur d'onde λ ;
. un plateau de chargement sur lequel est posé le composant électronique ou le substrat, la face dudit composant électronique ou du substrat sur laquelle sont localisées les billes d'hybridation faisant face à la lame transparente ;

. des moyens de déplacement (tels que par exemple un piston) pour déplacer le plateau de chargement selon une direction Z afin d'assurer l'écrasement partiel des billes d'hybridation contre la lame transparente ;

. des moyens optiques d'émission et d'acquisition, respectivement, d'un faisceau lumineux de longueur d'onde $\lambda$ apte à éclairer les billes d'hybridation à contrôler à travers la lame transparente et d'un faisceau lumineux réfléchis à travers la lame transparente par le composant électronique ou le substrat et les billes d'hybridation ;

. des moyens d'orientation (tels que par exemple une table de précision) pour orienter les moyens optiques ou le plateau selon des directions X et Y afin de diriger le faisceau lumineux vers les billes d'hybridation à contrôler ;

. des moyens de traitements (ou système de commande) aptes à commander les moyens d'orientation et les moyens de déplacement et à déterminer la conformité ou la non-conformité des billes d'hybridation à contrôler.

Selon un mode de réalisation préféré de ce dispositif, la lame transparente à la longueur d'onde $\lambda$ comporte une première plaque transparente à ladite longueur d'onde $\lambda$ et une seconde plaque transparente à la longueur d'onde $\lambda$ déposée sur ladite première plaque, la première plaque ayant une épaisseur plus faible que la seconde plaque et comportant une face dépolie, en contact avec la seconde plaque, l'autre face de la première plaque étant apte à être en contact avec les billes.

Selon l'invention, les moyens optiques comprennent une source lumineuse axiale assurant l'éclairage des billes d'hybridation à contrôler et une caméra C.C. D. couplée à ladite source lumineuse pour acquérir le signal réfléchi.

## Brève description des dessins

- La figure 1, déjà décrite, représente une bille d'hybridation d'une puce montée sur un substrat ;
- la figure 2 représente le schéma fonctionnel du procédé selon l'invention ;
- la figure 3 représente, schématiquement, le dispositif de contrôle de la hauteur des billes d'une puce;
- la figure 4 représente une puce hybridée par des billes de tailles différentes et la courbe du signal de réponse correspondant à chacune de ces billes ;
- les figures 5A et 5B représentent les dimensions des méplats mesurés sur deux billes écrasées, respectivement, légèrement et plus fortement, par la lame transparente ;
- la figure 6 montre les courbes représentatives de la relation entre l'écrasement et le méplat créé par cet écrasement pour des billes de hauteurs différentes.

## Exposé détaillé de modes de réalisation

Sur la figure 2, on a représenté le schéma fonctionnel du procédé selon l'invention. Ce procédé comporte une première étape 100 de chargement du dispositif (puce ou substrat) comportant les billes. Dans la suite de la description, à titre non limitatif, on prendra le cas particulier de la puce. Cette étape 100 consiste à charger la puce dont on veut contrôler chacune des billes dans le dispositif de mise en oeuvre qui sera décrit ultérieurement. La puce est donc placée dans le dispositif de façon à ce que ses billes d'hybridation soient face à la lame transparente à la longueur d'onde $\lambda$.

Aussi, à l'étape 200 du procédé de l'invention, la puce peut être positionnée par rapport à la lame transparente. De façon plus précise, cette étape 200 comporte une première sous-étape 210 qui consiste à mettre en contact les billes d'hybridation de la puce avec la lame transparente, de façon à ce qu'un premier contact soit établi entre des billes et la lame transparente. Une seconde sous-étape 220 consiste à affiner le positionnement de la puce par rapport à la lame, c'est-à-dire, plus précisément, à écraser au moins partiellement les billes d'hybridation de la puce sur la lame. L'écrasement 220 des billes d'hybridation sur la lame transparente est commandé par des moyens de commande automatiques, de façon à ce que l'écrasement des billes soit conforme aux critères de qualité souhaités par l'utilisateur.

Le procédé selon l'invention consiste, en outre, en une étape 300 de contrôle de la conformité de chacune des billes de la puce à contrôler. Cette étape 300 comporte une première sous-étape 310 d'éclairage. Cette sous-étape 310 consiste à éclairer tout ou partie de la puce munie des billes par un faisceau de lumière de longueur d'onde $\lambda$ envoyé selon une direction perpendiculaire au champ optique à contrôler. Ce champ peut comporter une ou plusieurs billes (on prendra par la suite le cas particulier d'un champ à une seule bille). Lorsque le champ est limité à une partie de la puce, le procédé de l'invention est répété de façon à contrôler l'ensemble de la puce par d'autres champs optiques. Le faisceau de lumière émis est réfléchi par la partie de la puce éclairée (notamment la bille et son méplat) et fournit ainsi un signal de réflexion qui est acquis dans la sous-étape 320. A partir de ce signal de réflexion acquis, une analyse est mise en oeuvre pour détecter la présence du méplat et/ou calculer la taille du méplat de la bille en cours de contrôle, la taille du méplat étant, comme on le verra par la suite, en relation directe avec la taille de la bille elle-même. Cette étape d'analyse est référencée 330. Lorsque la taille du méplat de la bille à contrôler a été calculée, un test de conformité (étape 330) permet de vérifier si la taille du méplat déterminée correspond à la taille du méplat d'une bille considérée conforme. Si ce test de conformité du méplat est validé, alors la bille est considérée conforme ; à l'opposé, lorsque ce test de conformité de la taille du méplat n'est pas validé, la bille est considérée non conforme.

Dans le mode de réalisation de l'invention, qui consiste en une simple détection de présence de billes conformes, on vérifie cette conformité des billes au moyen d'un critère de rejet relatif uniquement à la taille minimale que doivent avoir les billes. Dans ce cas, la taille minimale des billes peut être vérifiée par une simple détection de la présence d'un méplat sur chaque bille. Plus précisément, on considère comme critère le rejet des billes dont la taille est inférieure à n micromètres par rapport à la taille standard (ou théorique). Le procédé consiste, dans ce cas, à écraser sur n micromètres les billes sur la lame transparente. Les billes comportant un méplat sont considérées conformes ; celles ne présentant aucun méplat sont plus petites que la hauteur minimale définie par la taille standard diminuée de l'écrasement de n micromètres et donc considérées non-conformes.

Cette étape 300, telle que décrite ci-dessus, est réalisée pour chacune des billes de la puce.

Lorsque la dernière bille de la puce a été contrôlée, qu'elle ait été considérée conforme ou non-conforme, une étape 400 est mise en oeuvre pour retirer la puce du dispositif. Cette étape 400 consiste, de façon plus précise, en une première sous-étape 410 de séparation de la puce par rapport à la lame. En effet, les billes d'hybridation de la puce ayant été écrasées sur la lame transparente, le décollement de la lame avec des billes de la puce est réalisé durant cette sous-étape 410. Lorsque la puce a été séparée de la lame transparente, elle peut être déchargée du dispositif, afin, éventuellement, qu'une seconde puce soit chargée sur le dispositif pour y être contrôlée.

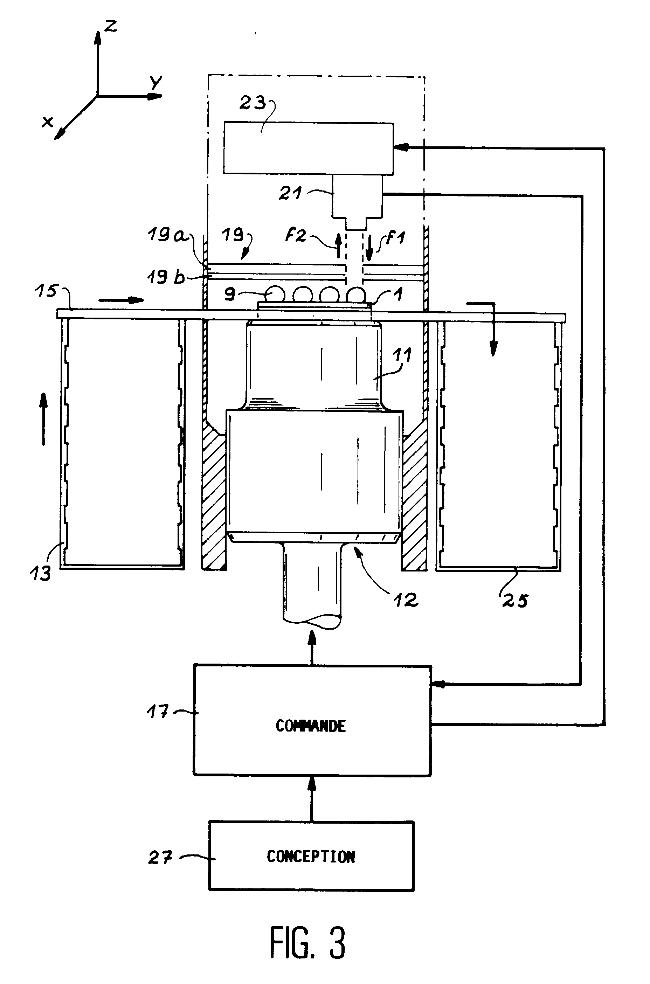

Sur la figure 3, on a représenté le dispositif permettant de mettre en oeuvre le procédé décrit sur la figure 2. Ce dispositif comporte un plateau de chargement 11 sur lequel est déposée la puce 1 à contrôler. Le chargement et le déchargement de la puce peuvent se faire de façon automatique par un système de chargement/déchargement 13 classique dans le domaine de la micro-électronique.

Pour permettre l'écrasement des billes 9, ce dispositif comporte une lame 19 transparente à la longueur d'onde émise par des moyens optiques qui seront décrits ultérieurement.

Selon un mode de réalisation préféré de l'invention, la lame transparente 19 comporte une première et une seconde plaques transparentes, la première plaque 19b, d'une épaisseur inférieure à la seconde plaque 19a, présentant un léger dépoli sur l'une de ses faces. La face de la première plaque 19b comportant ce dépoli est placée contre la seconde plaque de façon à ce que la face de la première plaque contre laquelle sont écrasées les billes soit lisse. La seconde plaque 19a permet de rigifier l'ensemble, cette seconde plaque étant apte à "encaisser" la pression exercée par l'écrasement des billes sur la première plaque 19b.

Le dépoli permet d'accentuer le contraste entre les méplats et le reste du champ observé. Dans cet exemple de réalisation, cette lame transparente 19 a une position fixe dans le dispositif. C'est le plateau de chargement 11, qui lui est mobile, qui assure la mise en contact puis l'écrasement des billes 9 de la puce 1 contre la lame transparente 19. De façon plus précise, ce plateau de chargement 11 est apte à être translaté dans la direction Z au moyen, par exemple, d'un piston 12 mobile dans la direction Z.

Selon un mode de réalisation de l'invention, le plateau de chargement 11 est fixé sur le piston 12. Ce piston 12 mobile selon Z est commandé par un système de commande 17, décrit plus en détail dans la suite de la description.

Selon un autre mode de réalisation de l'invention, le piston 12 mobile selon Z fait partie intégrante du plateau 11 de chargement ; le plateau de chargement 11 est alors apte à se translater lui-même dans la direction Z en fonction des commandes données par le système de commande 17.

Le dispositif selon l'invention comporte en outre des moyens optiques 21 qui consistent en l'association d'une source lumineuse apte à éclairer de façon axiale la ou les billes 9 de la puce 1 en regard desdits moyens avec un moyen de photodétection (par exemple une caméra C.C.D. ou une photodiode), apte à détecter le signal de réponse. On comprendra, par signal de réflexion, le signal résultant de la réflexion du faisceau lumineux envoyé par la source lumineuse sur la ou les bille(s) 9 en cours de contrôle et sur son méplat. Les traits pointillés représentés sur cette figure 3 entre les moyens optiques 21 et la bille 9 en cours de contrôle représentent le faisceau lumineux. De part et d'autre de ce faisceau lumineux, on a représenté la direction de ce faisceau lumineux par des flèches : ce faisceau lumineux est dirigé selon la flèche f1 lorsqu'il est projeté par la source lumineuse des moyens optiques 21 vers la ou les bille(s) 9 à contrôler. Le faisceau lumineux est réfléchi vers le moyen photodétecteur des moyens optiques 21 selon la flèche f2, lorsque le faisceau lumineux selon la flèche f1 s'est réfléchi sur le ou les bille(s) 9 et la puce 1.

Une table de précision en X et Y, référencée 23, est couplée aux moyens optiques 21 de façon à permettre le déplacement de ces moyens optiques 21. Cette table de précision 23 est commandée par le système de commande 17 selon la direction X et selon la direction Y. Ce système de commande 17 comporte une mémoire dans laquelle est enregistré le positionnement théorique de chaque bille de la puce 1. Il peut donc commander le déplacement de la table de précision 23 au-dessus de la puce 1 à contrôler. Cette table de précision 23 permet de positionner les moyens optiques 21 verticalement au-dessus de la ou des billes 9 choisies pour être contrôlée(s).

Lorsque toutes les billes 9 de la puce 1 ont été contrôlées de la façon expliquée par l'étape 300 de la figure 2, la puce 1 est déchargée du plateau de chargement 11. Ce déchargement de la puce 1 hors du plateau 11 s'effectue, de façon similaire à son chargement sur le plateau 11.

Le système de commande 17 assure, comme cité précédemment, la commande du déplacement du piston 12 mobile selon la direction Z, la commande du déplacement de la table de précision selon les directions X et Y, la commande du chargement et du déchargement de la puce à contrôler, respectivement, sur le plateau 11 et hors du plateau 11. Ce système de commande 17 assure également le traitement des données, c'est-à-dire la détection et/ou le calcul de la taille du méplat détecté sur la bille 9 en cours de contrôle. Ce système de commande 17 assure, en outre, le test de conformité de la bille 9. En effet, ce système de commande 17 est apte à effectuer l'acquisition de données fournies par des bandes de conception référencées 27, qui comportent les données (position théorique des billes, hauteur maximum et hauteur minimum des billes standards ou billes théoriques) relatives à la puce à contrôler. Il est également apte à effectuer l'acquisition des données fournies par le moyen de photodétection des moyens optiques 21 à partir desquelles il effectue la détection et/ou le calcul de la taille des méplats.

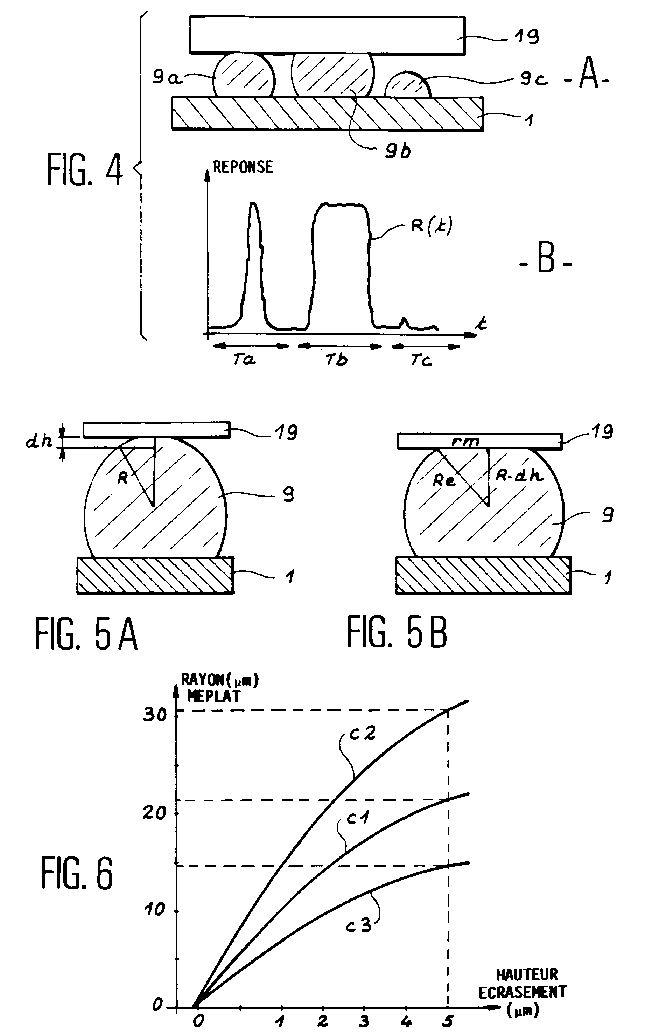

Sur la figure 4, on a représenté en partie A une puce hybridée par trois billes, toutes trois de tailles différentes. On a représenté en partie B une courbe représentative du signal de réponse obtenu pour chacune de ces trois billes.

De façon plus précise, on voit sur la partie A la lame transparente référencée 19, la puce 1 et trois billes d'hybridation référencées successivement 9a, 9b et 9c. Selon la représentation de cette figure 4, la puce hybridée 1 a été rapprochée de la lame transparente 19 en fonction d'un critère de conformité choisi par l'utilisateur. Ce rapprochement a donc écrasé certaines des billes de la puce 1 et donc créé les méplats de ces billes ; ces billes sont les billes 9a et 9b. La bille 9c étant de taille très inférieure aux billes 9a et 9b, le rapprochement de la puce 1 vers la lame transparente 19 ne provoque aucun écrasement de cette bille 9c.

Sur la partie B de la figure 4, on a représenté le signal de réponse du signal de réflexion obtenu par la caméra C.C.D. (ou la photodiode, selon le mode de réalisation choisi). Sur cette courbe, on a représenté sur l'axe des abscisses le temps t et sur l'axe des ordonnées le signal de réponse REPONSE enregistré pendant le déplacement de l'optique selon l'axe des billes. Durant la période Ta, on peut lire la réponse obtenue par la caméra C.C.D. pour la bille 9a. De même, durant la période Tb, on peut lire la réponse obtenue par la caméra C.C.D. pour la bille 9b. Et de façon identique, la période Tc montre le signal obtenu pour la bille 9c.

La partie A de la figure 4 montre bien la grande inhomogénéité des hauteurs des billes 9a, 9b et 9c. La partie B de la figure 4 représente l'analyse réalisée à partir du signal de réflexion obtenu pour chacune de ces billes. Cette courbe R(t) montre bien que l'inhomogénéité des billes 9a et 9b peut être jugée acceptable ou inacceptable en fonction des critères choisis par l'utilisateur, tandis que la bille 9c est forcément jugée inacceptable, c'est-à-dire non conforme, puisque son signal de réponse est quasi inexistant. On comprend donc bien que le défaut de la bille 9c peut être facilement repéré, ce qui conduit généralement à rejeter la puce 1 contenant une telle bille 9c.

Sur les figures 5A et 5B, on a représenté la bille 9 de la puce 1 contre la lame transparente 19. Sur la figure 5A, la bille 9 est simplement en contact avec la lame transparente 19, tandis que sur la figure 5B, la bille 9 est écrasée sur la lame transparente 19. On peut donc voir, sur la figure 5A, que la bille 9 ne comprend qu'un très léger méplat puisqu'elle est simplement en contact avec la lame transparente 19. Au contraire, sur la figure 5B, la bille 9 est écrasée contre la lame transparente 19, ce qui crée un méplat plus important sur la bille 9.

Sur la figure 5A, on a représenté le rayon R de la bille. En outre, on y a noté une différence de hauteur dh entre le point de contact de la bille sur la lame en figure 5A et celui en figure 5B. Cette différence de hauteur dh provient de l'écrasement de la bille 9 sur la figure 5B.

Sur la figure 5B, on a référencé Re le rayon de la bille au point d'extrémité du méplat, R - dh le rayon de la bille au point central du méplat et rm le rayon du méplat. Aussi, dans ce cas, la relation entre le rayon du méplat et le rayon de la bille 9 est :

$$rm^2 = Re^2 - (R - dh)^2$$

Dans le cas particulier où la valeur rm du méplat est faible, on peut assimiler le rayon Re de la bille au point d'extrémité du méplat avec le rayon de la bille R, ce qui permet de déterminer facilement le rayon de la bille R en fonction du rayon du méplat rm et de l'écrasement dh.

Sur la figure 6, on a représenté trois courbes C1, C2 et C3 représentant le rayon du méplat en micromètres (en ordonnée) par rapport à la hauteur dh d'écrasement en micromètres (en abscisse) d'une bille contre la lame transparente. Sur la courbe C1, on a représenté le rayon du méplat obtenu pour une bille de 50 micromètres de hauteur en fonction de la hauteur d'écrasement choisie. Sur la courbe C2, on a représenté le rayon du méplat d'une bille d'environ 100 micromètres en fonction des hauteurs d'écrasement de la bille contre la lame transparente. De façon similaire, la courbe C3 montre l'évolution du rayon du méplat d'une bille d'environ 25 micromètres en fonction de la hauteur d'écrasement de cette bille contre la lame transparente. Pour une bille de hauteur d'environ 50 micromètres, on peut lire sur la courbe C1 un rayon du méplat de l'ordre de 22 micromètres pour une hauteur d'écrasement d'environ 5 micromètres. Pour une même hauteur d'écrasement de 5 micromètres, on lit sur la courbe C2 que le rayon du méplat obtenu sur la bille de 100 µm est de l'ordre de 32 micromètres. De même, on lit sur la courbe C3 que pour une hauteur d'écrasement similaire de 5 micromètres, le rayon du méplat avoisine les 15 micromètres. On voit donc que pour une hauteur d'écrasement donnée, on peut relier la taille du méplat à la hauteur de la bille.

Avec une telle méthode, la précision sur la mesure de la hauteur de bille est importante et peut être de l'ordre du micron.

Ce procédé permet donc de vérifier la présence et/ou de calculer la hauteur de billes ayant notamment une taille de l'ordre de 10 micromètres à 300 micromètres. Une telle vérification peut être réalisée à une cadence de l'ordre de 150 millisecondes/bille, ce qui montre l'intérêt d'un tel procédé dans l'industrie.

**Revendications**

1. Procédé de contrôle de la conformité de billes d'hybridation (9) présentes sur une face d'un composant électronique ou d'un substrat (1), caractérisé en ce qu'il consiste en les étapes suivantes :

   a) Positionnement (210) des billes d'hybridation du composant électronique ou du substrat contre une lame transparente à une longueur d'onde $\lambda$ ;
   b) Ecrasement partiel (220) desdites billes d'hybridation sur la lame transparente, cet écrasement créant des méplats de billes sur la lame ;
   c) Eclairage des billes par un faisceau lumineux de longueur d'onde $\lambda$ à travers la lame transparente ;
   d) Acquisition (320-330) du signal réfléchi par les billes d'hybridation à contrôler ;
   e) Détermination (340) de la conformité ou de la non-conformité respective des billes d'hybridation à contrôler en fonction du signal réfléchi par chacune d'elles.

2. Procédé selon la revendication 1, caractérisé en ce que l'étape c) consiste à éclairer l'ensemble du composant électronique ou du substrat par le faisceau lumineux et l'étape d) consiste à acquérir le signal réfléchi par cet ensemble.

3. Procédé selon la revendication 1, caractérisé en ce que l'étape c) consiste à éclairer une partie du composant électronique ou du substrat par le faisceau lumineux, ladite partie étant susceptible de comporter au moins une bille et l'étape d) consiste à acquérir le signal réfléchi correspondant, ces étapes c) et d) étant répétées de façon à contrôler l'ensemble du composant électronique ou du substrat.

4. Procédé selon l'une quelconque des revendications 1 à 3, caractérisé en ce que l'étape b) d'écrasement des billes d'hybridation contre la lame transparente consiste à positionner le composant électronique ou le substrat à une distance prédéfinie de la lame transparente, cette distance correspondant à une hauteur théorique de bille de référence moins l'écart acceptable entre cette hauteur théorique de bille et une hauteur minimale des billes d'hybridation à contrôler pour que lesdites billes d'hybridation à contrôler soient conformes.

5. Procédé selon l'une quelconque des revendications 1 à 4, caractérisé en ce que l'étape e) de détermination de la conformité des billes consiste à détecter, à partir du signal réfléchi acquis, la présence ou non d'un méplat liée à une bille respectivement aux différents emplacements susceptibles d'être occupés par les billes.

6. Procédé selon l'une quelconque des revendications 1 à 4, caractérisé en ce que l'étape e) de détermination de la conformité des billes consiste à détecter à partir du signal réfléchi acquis, aux différents emplacements susceptibles d'être occupés par les billes, la présence ou non d'un méplat et à mesurer, dans le cas de la détection d'un méplat, la taille de ce dernier.

7. Dispositif de contrôle des dimensions des billes d'hybridation montées sur une face d'un composant électronique ou d'un substrat, mettant en oeuvre le procédé selon l'une quelconque des revendications 1 à 6, caractérisé en ce qu'il comporte :

   . une lame (19) transparente à une longueur d'onde $\lambda$ ;
   . un plateau de chargement (11) sur lequel est posé le composant électronique ou le substrat, la face dudit composant électronique ou du substrat sur laquelle sont localisées les billes d'hybridation faisant face à la lame transparente ;
   . des moyens (12) de déplacement selon une direction Z du plateau de chargement pour assurer l'écrasement partiel des billes d'hybridation contre la lame transparente ;
   . des moyens optiques (21) d'émission et d'acquisition, respectivement, d'un faisceau lumineux à la longueur d'onde $\lambda$ apte à éclairer des billes d'hybridation à contrôler du composant électronique ou du substrat à travers la lame transparente et d'un faisceau lumineux réfléchi à travers la lame transparente par le composant électronique ou le substrat et les billes d'hybridation ;
   . des moyens (17) de traitements aptes à commander les moyens de déplacement et à déterminer la conformité ou la non-conformité des billes d'hybridation à contrôler.

8. Dispositif selon la revendication 7, caractérisé en ce qu'il comporte des moyens (23) d'orientation des moyens optiques ou du plateau de chargement selon des directions X et Y pour diriger le faisceau lumineux vers les billes d'hybridation à contrôler, ces moyens d'orientation étant commandés par les moyens (17) de traitements.

9. Dispositif selon la revendication 7 ou 8, caractérisé en ce qu'il comporte des moyens (13, 15) de chargement automatiques du composant électronique ou du substrat sur le plateau de chargement, ces moyens de chargement étant commandés par les moyens de traitement.

10. Dispositif selon l'une quelconque des revendications 7 à 9, caractérisé en ce que la lame transparente à la longueur d'onde λ comporte une première plaque (19a) transparente à ladite longueur d'onde λ et une seconde plaque (19b) transparente à ladite longueur d'onde λ déposée sur ladite première plaque, la première plaque ayant une épaisseur plus faible que la seconde plaque et comportant une face dépolie, en contact avec la seconde plaque, l'autre face de la première plaque étant apte à être en contact avec les billes.

11. Dispositif selon l'une quelconque des revendications 7 à 10, caractérisé en ce que les moyens optiques comprennent une source lumineuse axiale assurant l'éclairage des billes d'hybridation à contrôler et une caméra C.C.D. couplée à ladite source lumineuse pour acquérir le signal réfléchi.

12. Dispositif selon l'une quelconque des revendications 7 à 11, caractérisé en ce que les moyens de traitements comportent une mémoire dans laquelle sont mémorisés des emplacements prédéfinis relatifs au positionnement susceptible d'être pris par les billes sur le composant électronique ou le substrat.

**Patentansprüche**

1. Verfahren zur Prüfung der Gleichförmigkeit von Hybridisierungskugeln (9), vorhanden auf einer Fläche bzw. Seite eines elektronischen Bauteils oder eines Substrats (1), **dadurch gekennzeichnet,** daß es die folgenden Schritte umfaßt:

a) Positionieren (210) der Hybridisierungskugeln des elektronischen Bauteils oder des Substrats auf einer transparenten Platte mit einer Wellenlänge λ;
b) Partielles Zusammendrücken (220) der besagten Hybridisierungskugeln auf der transparenten Platte, wobei dieses Zusammendrücken Kugelanflachungen auf der Platte erzeugt;
c) Beleuchten der Kugeln durch ein Lichtbündel der Wellenlänge λ durch die transparente Platte hindurch;
d) Erfassen (320-330) des durch die zu prüfenden Hybridisierungkugeln reflektierten Signals;
e) Feststellen (340) der Gleichförmigkeit oder der jeweiligen Ungleichförmigkeit der zu prüfenden Hybridisierungskugeln in Abhängigkeit von dem durch jede von ihnen refektierten Signal.

2. Verfahren nach Anspruch 1, dadurch gekennzeichnet, daß der Schritt c) darin besteht, die Ganzheit bzw. Gesamtheit des elektronischen Bauteils oder des Substrats mit einem Lichtbündel zu beleuchten, und der Schritt d) darin besteht, das durch diese Gesamtheit reflektierte Signal zu erfassen.

3. Verfahren nach Anspruch 1, dadurch gekennzeichnet, daß der Schritt c) darin besteht, einen Teil des elektronischen Bauteils oder des Substrats durch das Lichtbündel zu beleuchten, wobei besagter Teil geeignet ist, wenigstens eine Kugel zu enthalten, und der Schritt d) darin besteht, das entsprechende reflektierte Signal zu erfassen, und diese Schritte c) und d) wiederholt werden, um die Gesamtheit des elektronischen Bauteils oder des Substrats zu überprüfen.

4. Verfahren nach einem der Ansprüche 1 bis 3, dadurch gekennzeichnet, daß der Schritt b) des Zusammendrückens der Hybridisierungskugeln auf der transparenten Platte darin besteht, das elektronische Bauteil oder das Substrat mit einem festgelegten Abstand von der transparenten Platte zu positionieren, wobei dieser Abstand einer theoretischen Bezugskugelhöhe minus dem Abstand entspricht, der akzeptabel ist zwischen dieser theoretischen Bezugskugelhöhe und einer Mindesthöhe der zu prüfenden Hybridisierungskugeln, damit die zu prüfenden Hybridisierungskugeln konform sind.

5. Verfahren nach einem der Ansprüche 1 bis 4, dadurch gekennzeichnet, daß der Schritt e) zum Feststellen der Gleichförmigkeit der Kugeln darin besteht, aufgrund des erfaßten reflektierten Signals das Vorhandensein oder Nichtvorhandensein einer Anflachung zu detektieren, verbunden mit jeweils einer Kugel an den verschiedenen Stellen, die eventuell durch Kugeln besetzt sind.

6. Verfahren nach einem der Ansprüche 1 bis 4, dadurch gekennzeichnet, daß der Schritt e) zum Feststellen der Gleichförmigkeit der Kugeln darin besteht, aufgrund des erfaßten Signals an den verschiedenen, eventuell durch Kugeln besetzten Stellen das Vorhandensein oder Nichtvorhandensein einer Anflachung zu detektieren und im Falle der Detektion einer Anflachung deren Größe zu messen.

7. Vorrichtung zum Prüfen der Abmessungen der auf einer Fläche bzw. Seite eines elektronischen Bauteils oder eines Substrats angebrachten Hybridisierungskugeln, die das Verfahren nach einem der Ansprüche 1 bis 6 anwendet, **dadurch gekennzeichnet**, daß es umfaßt:

- eine transparente Platte (19) mit einer Wellenlänge λ;
- einen Ladetisch (11), auf dem das elektronische Bauteil oder das Substrat liegt, wobei die Seite des elektronischen Bauteils oder des Substrats, auf der die Hybridisierungskugeln sich befinden, der transparenten Platte gegenübersteht;
- Einrichtungen (12) zum Verschieben des Ladetisches in einer Richtung Z für das partielle Zusammendrücken der Hybridisierungskugeln auf der transparenten Platte;
- optische Einrichtungen (21) zum Senden und Empfangen von jeweils einem Lichtbündel mit der Wellenlänge λ, fähig, zu prüfende Hybridisierungskugeln des elektronischen Bauteils oder des Substrats durch die transparente Platte hindurch zu beleuchten, und einem durch die transparente Platte hindurch von dem elektronischen Bauteil oder dem Substrat und den Hybridisierungskugeln reflektierten Lichtbündel;
- Verarbeitungseinrichtungen (17), fähig die Verschiebeeinrichtungen zu steuern und die Gleichförmigkeit oder die Ungleichförmigkeit der zu prüfenden Hybridisierungskugeln festzustellen.

8. Vorrichtung nach Anspruch 7, dadurch gekennzeichnet, daß es Einrichtungen (23) zum Ausrichten der optischen Einrichtungen oder des Ladetischs in den Richtungen X und Y umfaßt, um das Lichtbündel auf die zu prüfenden Hybridisierungskugeln zu richten, wobei diese Ausrichteinrichtungen (23) durch die Verarbeitungseinrichtungen (17) gesteuert werden.

9. Vorrichtung nach Anspruch 7 oder 8, dadurch gekennzeichnet, daß sie automatische Einrichtungen (13, 15) zum Laden des elektronischen Bauteils oder des Substrats auf den Ladetisch umfassen, wobei diese Ladeeinrichtungen (13, 15) durch die Verarbeitungseinrichtungen gesteuert werden.

10. Vorrichtung nach einem der Ansprüche 7 bis 9, dadurch gekennzeichnet, daß die transparente Platte mit der Wellenlänge λ ein erstes transparentes Plättchen (19a) mit besagter Wellenlänge λ und ein zweites transparentes Plättchen (19b) dieser Wellenlänge λ umfaßt, abgeschieden auf dem ersten Plättchen, wobei das erste Plättchen eine geringere Dicke als das zweite Plättchen hat und eine matte Seite aufweist, die mit dem zweiten Plättchen in Kontakt ist, während die andere Seite des ersten Plättchens in Kontakt mit den Kugeln ist.

11. Vorrichtung nach einem der Ansprüche 7 bis 10, dadurch gekennzeichnet, daß die optischen Einrichtungen für die Beleuchtung der zu prüfenden Hybridisierungskugeln eine axiale Lichtquelle und eine mit dieser Lichtquelle gekoppelte CCD-Kamera zum Erfassen des reflektierten Signals umfassen.

12. Vorrichtung nach einem der Ansprüche 7 bis 11, dadurch gekennzeichnet, daß die Verarbeitungseinrichtungen einen Speicher umfassen, in dem vorher festgelegte Stellen abgespeichert sind, welche die eventuelle Positionierung betreffen, die durch die Kugeln auf dem Bauteil oder dem Substrat eingenommen wird.

**Claims**

1. Process for checking the conformity of the hybridization balls (9) present on one face of an electronic component or a substrate (1), characterized in that it consists of the following stages:

a) positioning (210) the hybridization balls of the electronic component or substrate against a strip transparent to the wavelength λ,

b) partial flattening (220) of said hybridization balls on the transparent strip, said flattening creating ball flats on the strip,

c) illuminating the balls with a light beam of wavelength λ through the transparent strip,

d) acquisition (320-330) of the signal reflected by the hybridization balls to be checked,

e) determination (340) of the conformity or non-conformity of the hybridization balls to be checked as a function of the signal reflected by each of them.

2. Process according to claim 1, characterized in that the stage c) consists of illuminating the assembly of the electronic component or substrate by the light beam and stage d) consists of acquiring the signal reflected by said assembly.

3. Process according to claim 1, characterized in that stage c) consists of illuminating part of the electronic component or substrate by the light beam, said part being liable to have at least one ball and stage d) consists of acquiring the corresponding reflected signal, said stages d) and e) being repeated so as to check the assembly of the electronic component or substrate.

4. Process according to any one of the claims 1 to 3, characterized in that the stage b) of flattening the hybridization balls against the transparent strip consists of positioning the electronic component or substrate at a previously defined distance from the transparent strip, said distance corresponding to a theoretical reference ball height, less the acceptable deviation between said theoretical ball height and a minimum height of the hybridization balls to be checked in order to ensure that said balls are in conformity.

5. Process according to any one of the claims 1 to 4, characterized in that the stage e) of determining the conformity of the balls consists of detecting, from the acquired reflected signal, the presence or absence of a flat linked with a ball respectively at the different locations liable to be occupied by balls.

6. Process according to any one of the claims 1 to 4, characterized in that the stage e) of determining the conformity of the balls consists of detecting, from the acquired reflected signal, at the different locations liable to be occupied by the balls, the presence or absence of a flat and measuring in the case of the detection of a flat the size of the latter.

7. Device for checking the dimensions of hybridization balls mounted on one face of an electronic component or a substrate, for performing the process according to any one of the claims 1 to 6, characterized in that it comprises:

   a strip (19) transparent to the wavelength λ,

   a loading table (11) on which is placed the electronic component or substrate, the face of said electronic component or substrate on which are located the hybridization balls facing the transparent strip,

   means (12) for the displacement in a direction Z of the loading table in order to ensure the partial flattening of the hybridization balls against the transparent strip.

   optical means (21) for the emission and acquisition respectively of a light beam at the wavelength λ able to illuminate the hybridization balls to be checked of the electronic component or substrate through the transparent strip and a light beam reflected through the transparent strip by the electronic component or substrate and the hybridization balls,

   processing means (17) able to control the displacement means and determine the conformity or non-conformity of the hybridization balls to be checked.

8. Device according to claim 7, characterized in that it has means (23) for the orientation of the optical means or the loading table in directions X and Y in order to direct the light beam towards the hybridization balls to be checked, said orientation means being controlled by the processing means (17).

9. Device according to claim 7 or 8, characterized in that it incorporates means (13,15) for the automatic loading of the electronic component or substrate on the loading table, said loading means being controlled by the processing means.

10. Device according to any one of the claims 7 to 9, characterized in that the strip transparent to the wavelength λ has a first plate (19a) transparent to said wavelength λ and a second plate (19b) transparent to said wavelength λ deposited on said first plate, the first plate being less thick than the second plate and having a frosted face in contact with the second plate, the other face of the first plate being contactable with the balls.

11. Device according to any one of the claims 7 to 10, characterized in that the optical means incorporate an axial light source ensuring the illumination of the hybridization balls to be checked and a CCD camera coupled to said light source in order to acquire the reflected signal.

12. Device according to any one of the claims 7 to 11, characterized in that the processing means comprise a memory in which are stored the previously defined locations relative to the positioning liable to be assumed by the balls on the electronic component or substrate.

EP 0 627 611 B1

FIG. 1

FIG. 2

CHARGEMENT PUCE — 100

MISE AU CONTACT LAME-PUCE — 200
210
220
ECRASEMENT

ECLAIRAGE — 300
310
ACQUISITION
320
ANALYSE
330

SEPARATION LAME-PUCE — 400
420
410
DECHARGEMENT PUCE

11

FIG. 3

FIG. 4

- A -

9a    9c    9b    19    1

REPONSE

R(t)

- B -

Ta    Tb    Tc

dh    19    R    9    1

FIG. 5 A

rm    19    Re    R·dh    9    1

FIG. 5 B

FIG. 6

RAYON (µm) MEPLAT

30    c2
20    c1
10    c3

0   1   2   3   4   5

HAUTEUR ECRASEMENT (µm)